Europäisches Patentamt

European Patent Office

Office européen des brevets

(11) Publication number: **0 025 607**
**B1**

## EUROPEAN PATENT SPECIFICATION

(45) Date of publication of patent specification: **02.01.85**

(51) Int. Cl.⁴: **H 03 G 3/20**

(21) Application number: **80105552.6**

(22) Date of filing: **17.09.80**

(54) Method of and circuit for automatic gain control in electronic equipments.

(30) Priority: **18.09.79 IT 6882879**

(43) Date of publication of application:
**25.03.81 Bulletin 81/12**

(45) Publication of the grant of the patent:
**02.01.85 Bulletin 85/01**

(84) Designated Contracting States:
**DE FR GB NL**

(56) References cited:
**FR-A-2 439 506**
**IT-A- 980 804**
**US-A-3 983 361**
**US-A-4 191 995**

**IEEE TRANSACTIONS ON CIRCUITS AND SYSTEMS, vol. CAS-22, no. 2, February 1975, New York, US D.R. MORGAN: "On discrete-time AGC amplifiers", pages 135-146**
**RADIO MENTOR ELECTRONIC, vol. 38, no. 8, August 1972, München, DE NIEBLER et al. "Multiplizierer steuert Verstärkung", pages 370-373**
(73) Proprietor: **CSELT Centro Studi e Laboratori Telecomunicazioni S.p.A.**
**Via Guglielmo Reiss Romoli, 274**
**I-10148 Turin (IT)**

(72) Inventor: **di Tria, Paolo**
**C. so Sebastopoli, 310**
**Torino (IT)**

(74) Representative: **Riederer Freiherr von Paar zu Schönau, Anton**
**Freyung 615 Postfach 2664**
**D-8300 Landshut (DE)**

## Description

The present invention relates to a method of and a circuit arrangement for automatic gain control in electronic equipments, particularly in telecommunication equipments, as defined in the prior art portions of claims 1 and 3. Such method and arrangement are known from US—A 3 983 381.

The need to insert a closed loop gain control device into an electronic equipment is encountered whenever signals with variable amplitude are present at the equipment input and the devices in the equipment are to operate on signals with predetermined and fixed level.

Usually a gain control circuit must obtain from the variable amplitude input signal a control variable that, multiplied by the signal itself, gives the output signal with the predetermined level; i.e. the control circuit is to supply a variable of the kind $Xo=R/S$, where R is the reference level and S the input signal level. Theoretically, variable $Xo$ could be either directly supplied or reached through successive approximations by the use of an iterative algorithm, like the gradient algorithm, that minimizes the square error $(X—Xo)^2$, where X is a generic approximated value of the control variable.

By such an algorithm, value $X_n$ of the control variable at instant n will be given by the relationship

$$X_n=X_{n-1}-\beta\Delta \qquad (1),$$

where $X_{n-1}$ is the value of X at instant n−1, $\beta$ is a parameter that regulates the stability of the feed back loop controlling the gain, and $\Delta$ is the gradient of the square error.

Replacing $\Delta$ by its value and taking into account the expression of $Xo$, relationship (1) can also be written

$$X_n=X_{n-1}-\frac{\beta}{S}(X_{n-1}S—R) \qquad (2)$$

The use of the gradient algorithm would be particularly desirable, due to its simplicity and speed of convergence; anyway both the direct calculation of $Xo$ and the realization of a circuit implementing relationship (2) give rise to considerable practical difficulties, as divisions by variable quantities are to be effected and components designed for that purpose are not commercially available.

To solve this problem, in Italian Patent No. 980804 a digital circuit for automatic gain control has been proposed where the possible values of ratio R/S are stored in a read only memory. Yet, this known circuit can be employed only when the signal to be controlled can have but a limited number of levels; otherwise, as the memory size grows exponentially with the number of bits necessary to define the levels, the necessary memory capacity would become too high, making the circuit expensive and giving rise to problems of operation speed.

In the prior art according to US—A 3 983 381, the automatic gain control processes the error without effecting divisions by variable quantities. In this control system which is designed for digital signals, the feed back loop contains an accumulator loop by which an iterative adaption of the control variable takes place. However, the control variable must not become negative which would make the control loop unstable. Such negative control variables could occur in case of a very great difference between the actual output signal level and the reference level. Thus, another control loop is provided controlling the polarity of the reference signal, and a digital rectifier is provided rectifying the accumulator output signal such that the resulting control variable may always be positive. Thus, the prior art circuitry is necessarily complex.

To overcome these disadvantages, the present invention provides an easy method and a simple circuit as characterized in claims 1 and 3, respectively, of or for, respectively, automatic gain control that allow the application of the gradient algorithm making only multiplications and additions. The invention can be used whatever the number of possible levels for the signal to be controlled may be.

The process of the invention starts from replacing, in relationship (2), the factor 1/S (in which the variable is the denominator) by factor X/R, in which the denominator is a constant, the replacement being made so as to keep the value of $(X \cdot S—R)$ limited. The division by a constant factor, previously known, does not imply practical problems.

The characteristics of the invention will become clearer from the following description of a preferred embodiment of said circuit, given by way of example and not in a limiting sense and represented as a block diagram in the annexed drawing.

In such block diagram reference CG denotes the control circuit of the invention while reference UT denotes the utilization device for the controlled signals supplied by CG; more particularly UT may be a device belonging to a telecommunication equipment, for instance a modem, a multi-frequency signal receiver, etc.

In circuit CG, a first multiplier M1 receives at a first input (connection 1) the input signal S to be controlled which may be analog or a digital signal, and at a second input (connection 2) the control variable X. It effects the product thereof and supplies in the steady state the output signal locked to the reference value.

A circuit SA "saturates" product $X \cdot S$, that is, when said product is higher than a certain maximum value or lower than a minimum value, SA supplies at the output such maximum or minimum value, respectively. The presence of circuit SA is necessary because, due to the replacement of factor 1/S by factor X/R in the expression of the gradient, this has a non-linear trend and for values much higher or much lower than Xo, the correction made would cause instability in the circuit; the maximum and minimum thresholds of SA will be chosen such as to avoid this possibility, depending on the actual operative conditions. Devices performing as SA are well known in the art, and they need not be described in detail.

Block RC denotes a device that supplies at predetermined subsequent instants at the output an indication signal of the level of its input signal, i.e. of the output signal of CG:RC can be a simple sampler in case of d.c. signals, or a power detector or an envelope detector with modulus computation, dependant on the nature of signal S. Signals CK supplied by a timing device (not shown) will control the emission of information by RC only in the desired instants.

A first adder SM1 has a first input (denoted by +) connected to the output of RC, and receives at a second input (denoted by —) the reference signal R with predetermined level.

The signal outgoing from SM1 is the difference between the desired value and the actual value of the controlled output signal, and thus is an error signal.

A second multiplier M2 correlates said difference signal (error signal) with the value reached by the control variable at the preceding instant, supplied by a delay element RT, and supplies at the output a product signal proportional to the approximated gradient of the square error.

Block NR normalizes the product signal outgoing from M2 with respect to the reference level value, that is it computes the ratio between said signal and the value of R, and at the same time reduces its value multiplying it by factor $\beta$ of relationship (1) for stability reasons. In the practical embodiment circuit NR will merely scale down the input word, if the signals are digital; if they are analog, NR may be a voltage divider and will effect a real product by factor $\beta/R$ that is constant and then can be preset. The output signal of NR is the difference updating the control variable.

A second adder SM2 has a first input (denoted by +) connected to the output of delay element RT and a second input (denoted by —) connected to the output of NR; SM2 algebraically sums the updating value outgoing from NR and the present value of X which is the previous instant output value of SM2, thereby generating a sum signal to become the new value of the control variable. The output of SM2 is connected to the input of delay element RT whose output is connection 2 already examined.

In case of analog signals the set of SM2 and RT will be realized by an integrator.

A branch of connection 2 supplies the control variable to a possible signal detector RS to detect the presence or absence of signals on line 1. The fact that X exceeds an upper threshold or comes below a lower threshold can be interpreted as the absence or the presence of the signal on connection 1: under these conditions, detector RS could present on its output 3 connected to utilization device UT a disabling or enabling signal, respectively.

The operation of the device can be easily deduced from the above description: input signal S arriving on connection 1 is multiplied in M1 by the value of X present at that instant on connection 2, for instance value $X_{n-1}$; the product $S \cdot X_{n-1}$, possibly limited by SA, is the controlled output signal that is supplied both to the utilization device UT and to detector RC, that at the instant determined by CK will supply the quantity to be compared with reference level R; if the value of such quantity is different from R, SM1 supplies an error signal $(S \cdot X_{n-1} - R)$ that is multiplied in M2 by the same value $X_{n-1}$; the product signal $X_{n-1} \cdot (S \cdot X_{n-1} - R)$, that is proportional to the approximated gradient, is normalized in NR by multiplying it by factor $\beta/R$, and the normalized value is algebraically summed up in SM2 to $X_{n-1}$, thereby supplying a sum signal to become the new value of the control variable

$$X_n = X_{n-1} - \frac{\beta}{R}(X_{n-1} \cdot S - R) \cdot X_{n-1}.$$

Said new value is sent to the output of RT and thence to multiplier M1 to determine a new value of the controlled signal, and possibly to detector RS. The updating will go on till the output of SM1 becomes zero, that is till the control variable reaches value Xo.

It is clear that what described is given only by way of example and not in a limiting sense and that variations and modifications are possible without going of the scope of the invention. More particularly SM1 could supply the error signal $(R - SX_n)$ instead of $(SX_n - R)$; in this case the normalized signal will be actually added to the preceding signal.

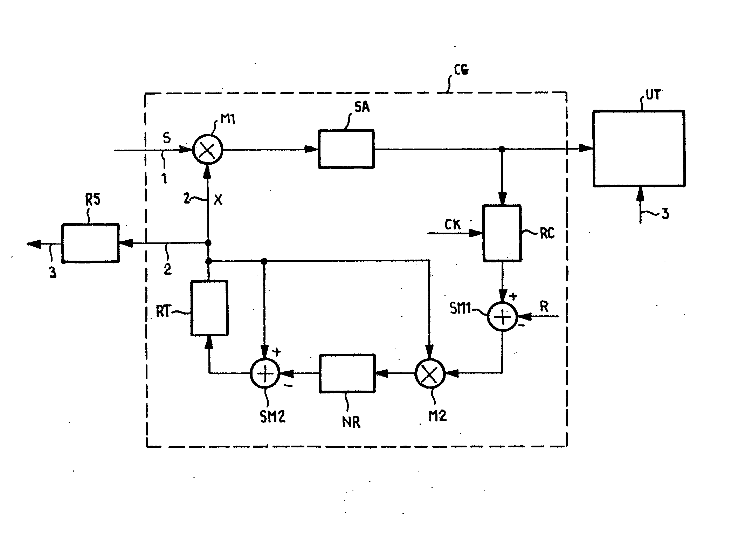

**Claims**

1. Method of automatic gain control in electronic equipments, particularly in telecommunication equipments, wherein a variable-amplitude input signal is converted to an output signal locked to a reference level, the method comprising the step of:

— multiplying the input signal (S) by a control variable (X) for deriving the output signal;
— iteratively updating the value of the control variable at subsequent predetermined instants upon consideration of a comparison between the level of the output signal and the reference level;
— for carrying out said comparison, extracting (in RC) at the subsequent instants the actual level of the output signal and determining the difference between this actual level and the reference level (R), resulting in a difference signal;
— multiplying (in M2) said difference signal by the value the control variable has reached at the previous instant, resulting in a product signal;
— adding (in SM2) a signal proportional to the product signal, for obtaining a sum signal, to a value which was the sum signal of this addition at the previous instant;
— and using the sum signal for deriving the control variable (X),

characterized in that

— the output signal, before extraction of the actual level thereof, is subjected (in SA) to a saturation with respect to maximum deviation from the reference level (R) in positive and negative directions, and
— that a fixed reference level (R) is used.

2. Method according to claim 1, characterized in that the sum signal is an updated value of the control variable (X) itself.

3. Method according to claim 2, characterized in that in each instant, the sum signal of the previous instant is used as control variable (X).

4. Circuit arrangement for carrying out the method according to any of claims 1 to 3, comprising:

— a first multiplier (M1), that multiplies the input signal (S) by the control variable (X) and supplies a controlled signal;
— a circuit (RC) supplying a signal proportional to the level of the controlled signal at predetermined instants;
— a first adder (SM1), that receives the output signal of said circuit (RC) and a signal at the reference level and supplies an error signal as the difference between said two signals;
— a second multiplier (M2), that multiplies said error signal by the value reached by the control variable at the previous instant;
— a second adder (SM2) following the second multiplier (M2), that adds the multiplication product thereof with its own output signal at the previous instant, thereby supplying a new output signal;
— a delay element (RT) delaying the output signal of the second adder (SM2) between the output and the one of the inputs thereof by the repetition period of the subsequent instants,

characterized in that between the first multiplier (M1) and the circuit (RC) supplying the signal proportional to the level of the controlled signal, a saturation circuit (SA) is inserted which effects a control of the maximum and minimum values of the controlled signal, the output of the saturation circuit (SA) also being connected to utilization devices (UT) of the controlled signal, and that the output (2) of the delay element (RT) is connected to the control input of the first multiplier (M1).

5. Circuit arrangement to claim 4, characterized in that the output of said delay element (RT) is connected to a detector (RS) which recognizes the presence or absence of the signal on the basis of the value of the control variable, said detector (RS) supplying enabling or disabling signals, respectively, for the utilization devices (UT) of the controlled signal.

**Revendications**

1. Procédé pour le réglage automatique du gains dans des installations électroniques, et plus particulièrement des installations pour télécommunications, ou un signal d'entrée d'amplitude variable est converti dans un signal de sortie verrouille5 à un niveau de référence, le procédé comprenant les opérations suivantes:

— multiplication du signal d'entrée (S) par une variable de réglage (X) pour obtenir le signal de sortie;
— mise à jour itérative de la valeur de la variable de réglage à des instants prédéterminés successifs, d'après une comparaison entre le niveau du signal de sortie et le niveau de référence;
— pour l'effectuation de la comparaison, extraction (en RC), aux instants successifs, du niveau actuel du signal de sortie et détermination de la différence entre ce niveau actuel et le niveau de référence (R), de facon à obtenir un signal différence;
— multiplication (en M2) entre ledit signal différence et la valeur atteinte par la variable de réglage à l'instant précédent de façon à obtenir un signal produit;
— addition (en SM2), pour obtenir un signal somme, entre un signal proportionnel au signal produit et une valeur qui est le signal somme obtenu de l'addition effectuée à l'instant précédent,
— et utilisation du signal somme pour obtenir la variable de réglage (X);

caracterisé en ce que

— le signal de sortie, avant l'extraction de son niveau actuel, est soumis (en SA) à une saturation par rapport à la déviation maximum du niveau de référence (R), dans les directions positive et négative, et
— en ce qu'on emploie un niveau de référence (R) fixe.

2. Procédé suivant la revendication 1, caractérisé en ce que le signal somme est une valeur mise à jour de la variable de réglage (X).

3. Procédé suivant la revendication 2, caractérisé en ce qu'à chaque instant on emploie comme variable de réglage (X) le signal somme relatif à l'instant précédent.

4. Circuit pour la réalisation du procédé suivant l'une quelconque des revendications 1 à 3, comprenant:

— un premier multiplicateur (M1) qui multiplie le signal d'entrée (S) par la variable de réglage (X) et donne un signal réglé;

— un circuit (RC) qui donne un signal proportionnel au niveau du signal réglé à des instants prédéterminés;

— un premier additionneur (SM1), qui reçoit le signal de sortie dudit circuit (RC) et un signal dont le niveau est égal au niveau de référence, et émet un signal d'erreur comme différence entre lesdits deux signaux;

— un second multiplicateur (M2), qui multiplie ledit signal d'erreur par la valeur atteinte par la variable de réglage à l'instant précédent,

— un second additionneur (SM2), en série au second multiplicateur (M2), qui somme le produit calculé dans ce dernier et son même signal de sortie relatif à l'instant précédent, de façon a fournir un nouveau signal de sortie;

— un élément de retard (RT), qui retarde le signal de sortie du second additionneur (SM2), entre la sortie et une des entrées de celui-ci, de la période de répétition des instants successifs,

caractérisé en ce qu' entre ledit premier multiplicateur (M1) et le circuit (RC) qui donne le signal proportionnel au niveau du signal réglé il y a un circuit de saturation (SA) qui effectue un contrôle sur les valeurs maxima et minima du signal réglé, la sortie du circuit de saturation (SA) étant aussi connectée à des dispositifs (UT) d'utilisation du signal réglé, et en ce que la sortie (2) de l'élément de retard (RT) est connectée à l'entrée de réglage du premier multiplicateur (M1).

5. Circuit suivant la revendication 4, caractérisé en ce que la sortie dudit élément de retard (RT) est connectée à un détecteur (RS) qui reconnàitla présence ou l'absence du signal d'aprés la valeur de la variable de réglage, ce détecteur (RS) émettant un signal de validation ou respectivement d'invalidation pour les dispositifs (UT) d'utilisation du signal réglé.

## Patentansprüche

1. Verfahren zur automatischen Verstärkungsregelung in elektronischen Ausrüstungen, insbesondere in Fernmeldeanlagen, bei dem ein Eingangssignal veränderlicher Amplitude in ein auf einen Bezugpegel festgelegtes Ausgangssignal umgewandelt wird, mit den folgenden Verfahrensschritten:

— man multipliziert das Eingangssignal (S) zur Ableitung des Ausgangssignals mit einer Regelvariablen (X);

— man schreibt den Wert der Regelvariablen iterativ zu aufeinanderfolgenden vorbestimmten Zeitpunkten unter Berücksichtigung eines Vergleichs zwischen dem Pegel des Ausgangssignals und dem Bezugspegel fort;

— man extrahiert (in RC) zur Durchführung des Vergleichs zu den aufeinanderfolgenden Zeitpunkten den tatsächlichen Pegel des Ausgangssignals und bestimmt die Differenz zwischen diesem tatsächlichen Pegel und dem Bezugspegel (R), woraus ein Differenzsignal resultiert;

— man multipliziert (in M2) das Differenzsignal mit dem Wert, den die Regelvariable zum vorhergehenden Zeitpunkt erreicht hat, woraus ein Produktsignal resultiert;

— man addiert (in SM2) ein dem Produktsignal proportionales Signal zum Erhalten eines Summensignals mit einem Wert, der das Summensignal dieser Addition zum vorhergehenden Zeitpunkt war;

— und man verwendet das Summensignal zum Ableiten der Regelvariablen (X),

dadurch gekennzeichnet, daß man

— das Ausgangssignal, vor dem Abnehmen von dessen tatsächlichem Pegel, hinsichtlich einer maximalen Abweichung vom Bezugspegel (R) in positiver und in negativer Richtung einer Sättigung unterwirft (in SA) und
— einen festen Bezugspegel (R) verwendet.

2. Verfahren nach Anspruch 1, dadurch gekennzeichnet, daß das Summensignal ein fortgeschriebener Wert der Regelvariablen (X) selbst ist.

3. Verfahren nach Anspruch 2, dadurch gekennzeichnet, daß zu jedem Zeitpunkt das Summensignal des vorhergehenden Zeitpunkts als Regelvariable (X) verwendet wird.

4. Schaltungsanordnung zum Durchführen des Verfahrens nach einem der Ansprüche 1 bis 3, mit folgenden Einzelschaltungen:

— einem ersten Multiplizierer (M1), der das Eingangssignal (S) mit der Regelvariablen (X) multipliziert und ein geregeltes Signal abgibt;

— einer ein dem Pegel des geregelten Signals proportionales Signal zu vorgegebenen Zeitpunkten liefernden Schaltung (RC);

— einem ersten Addierer (SM1), der das Ausgangssignal dieser Schaltung (RC) und ein Signal mit dem Bezugspegel empfängt und als Differenz zwischen diesen beiden Signalen ein Fehlersignal abgibt;

— einem zweiten Multiplizierer (M2), der das Fehlersignal mit dem von der Regelvariablen zum vorhergehenden Zeitpunkt erreichten Wert multipliziert;

— einem zweiten Addierer (SM2), der dem zweiten Multiplizierer (M2) folgt und dessen Multiplikationsprodukt mit seinem eigenen Ausgangssignal des vorhergehenden Zeitpunkts addiert, womit er ein neues Ausgangssignal liefert;

— einem Verzögerungselement (RT), das das Ausgangssignal des zweiten ten Addierers (SM2) zwischen dessen Ausgang und einem von dessen Eingängen um die Repetitionsperiode der aufeinanderfolgenden Zeitpunkte verzögert,

dadurch gekennzeichnet, daß zwischen dem ersten Multiplizierer (M1) und der Schaltung (RC), die das dem Pegel des geregelten Signals proportionale Signal liefert, eine Sättigungsschaltung (SA) eingeschaltet ist, die eine Steuerung der Maximalwerte und der Minimalwerte des geregelten Signals bewirkt, wobei der Ausgang der Sättigungsschaltung (SA) auch mit Verwendungsschaltungen (UT) des geregelten Signals verbunden ist, und daß der Ausgang (2) des Verzögerungselements (RT) mit dem Regeleingang des ersten Multiplizierers (M1) verbunden ist.

5. Schaltungsanordnung nach Anspruch 4, dadurch gekennzeichnet, daß der Ausgang des Verzögerungselements (RT) mit einem Detektor (RS) verbunden ist, der das Vorhandensein oder Nichtvorhandensein des Signals auf der Grundlage des Werts der Regelvariablen erkennt und der für die Verwendungsvorrichtungen (UT) des geregelten Signals aktivierende bzw. desaktivierende Signale liefert.